Europäisches Patentamt

European Patent Office

Office européen des brevets

(11) Publication number: **0 047 112**
**B1**

(12) **EUROPEAN PATENT SPECIFICATION**

(45) Date of publication of patent specification: **27.11.85**

(51) Int. Cl.⁴: **H 01 L 21/316, H 01 L 21/68**

(21) Application number: **81303829.6**

(22) Date of filing: **21.08.81**

(54) Method of forming phosphosilicate glass films.

(30) Priority: **29.08.80 JP 119357/80**
**05.11.80 JP 155361/80**

(43) Date of publication of application:
**10.03.82 Bulletin 82/10**

(45) Publication of the grant of the patent:
**27.11.85 Bulletin 85/48**

(84) Designated Contracting States:
**DE FR GB NL**

(56) References cited:
**US-A-4 098 923**

**Patent Abstracts of Japan Vol. 3, No. 146, 4 December 1979 page 56E156**
**Patent Abstracts of Japan Vol. 2, No. 94, 5 August 1978 page 4463E78**

(73) Proprietor: **FUJITSU LIMITED**
**1015, Kamikodanaka Nakahara-ku**
**Kawasaki-shi Kanagawa 211 (JP)**

(72) Inventor: **Miyamoto, Hidekazu**
**1019-11 Aihara**
**Sagamihara-shi Kanagawa 299 (JP)**
Inventor: **Maeda, Mamoru**
**2-5-6-403 Toyogaoka**
**Tama-shi Tokyo 192-02 (JP)**
Inventor: **Shioya, Yoshimi**
**16-6-402 Namiki 1-chome Kanazawa-ku**
**Yokohama-shi Kanagawa 236 (JP)**
Inventor: **Takagi, Mikio**
**6-20-3 Nagao Tama-ku**
**Kawasaki-shi Kanagawa 213 (JP)**

(74) Representative: **Rackham, Stephen Neil et al**
**GILL JENNINGS & EVERY 53-64 Chancery Lane**
**London WC2A 1HN (GB)**

Courier Press, Leamington Spa, England.

## Description

The present invention relates to a method of depositing phosphosilicate glass films on the surfaces of substrates and partly formed semiconductor substrates such as silicon substrates or aluminium wire patterns formed on silicon substrates.

As is known in the art, a phosphosilicate glass film is widely used as a protective coating, a passivation film, an interlaminar insulating film of multiwire pattern layers, or a solid diffusion source for an N-type impurity. To deposit phosphosilicate glass films chemically, a so-called "atmospheric pressure chemical vapour deposition method" is often used and this method results in the production of phosphosilicate glass films having a uniform thickness and having a uniform phosphorous concentration. In the atmospheric pressure method, a phosphosilicate glass film is deposited on a substrate in, for example, a bell-jar type reaction apparatus from a reaction gas mixture including monosilane ($SiH_4$), phosphine ($PH_3$) and oxygen ($O_2$) under atmospheric pressure and at a temperature of between 350° and 450°C. However, the atmospheric pressure chemical vapour deposition method has a disadvantage in that it is not susceptible to mass production and a further disadvantage in that cracks are likely to be generated in the deposited films during for example, a subsequent annealing treatment at approximately 450°C for example to remove the surface state formed in the semiconductor device after the deposition of the phosphosilicate glass film. The generation of these cracks results in a decrease in the reliability of the finished semiconductor device.

In addition, a so-called "low pressure chemical vapour deposition" method is also used such as described in US—A—4098923. In this method, a phosphosilicate glass film is deposited on a substrate from a reaction gas mixture including a silicon compound gas and an oxidising gas under a low pressure typically 133.32 Pa (1 Torr) or less and at a temperature of between 350° and 450°C.

The deposition is carried out in a reaction tube made of, for example, quartz having an inner diameter of 120 mm diameter and having a uniform heating zone of length of approximately 100 mm. The gases are fed into the reaction tube through at least two gas feed pipes having gas outlets distributed along them, the silicon compound gas being introduced through one feed pipe and the oxidising gas being introduced through another of the gas feed pipes, and an exhaust outlet is located at an end of the reaction tube. A number of substrates or partly formed semiconductor devices are placed on a wafer holder with their principal surfaces parallel and substantially perpendicular to the axis of the reaction tube.

However, there are problems in these conventional low pressure chemical vapour deposition methods because the thicknesses and the quality of the phosphosilicate glass film deposited on the principal surfaces of the substrates varies with the amount of the oxidising gas present. For instance, the variation in ths film thickness of the phosphosilicate glass films varies by as much as ±30%, in this conventional apparatus. For this reason, the phosphosilicate glass films are conventionally deposited at a mol ratio of $O_2/SiH_4$ in the reaction feed gas of less than 2 (i.e. approximately 0.5—1.5). However, in this case hydrogen remains and is included in the deposited phosphosilicate glass films since the amount of oxidising gas present in the reaction gas mixture is insufficient completely to oxidise the silicon compound gas. When the phosphosilicate glass film contains a relatively large amount of hydrogen, cracks are likely to be generated in the deposited phosphosilicate glass films. The formation of the cracks in the deposited phosphosilicate glass films makes the phosphosilicate glass films useless and, also, a relatively large amount of hydrogen causes an accumulation of phosphorus at the interface of the substrate and the phosphosilicate glass film when the phosphorous accumulated phosphosilicate glass films are heat-treated at a temperature of 900°C or more.

Accordingly, an object of the present invention is to overcome these problems in the deposition of phosphosilicate glass films and to provide a method of deposition which enables stable phosphosilicate glass films having a uniform thickness and quality and containing no substantial amount of hydrogen to be deposited on substrates under mass production conditions.

In an embodiment of this invention a phosphosilicate glass film is deposited on a number of substrates located in an elongate reaction tube with at least two gas feed pipes having gas outlets distributed along them arranged along the inside of the reaction tube with the silicon compound gas being introduced through one of the gas feed pipes and the oxidising gas being introduced through another of the gas feed pipes, and with a gas being fed through an inlet into the reaction tube to ensure a smooth flow of the silicon compound gas and the oxidising gas mixture through the reaction tube.

This arrangement enables a stable phosphosilicate glass film to be deposited on substrates using mass production techniques. Particular embodiments of methods in accordance with this invention enable glass films having a low phosphorus concentration, and therefore, having an excellent water-vapour resistance and enable stable phosphosilicate glass films to be produced in which no substantial cracking occurs during a subsequent annealing of the semiconductor device after the deposition of the phosphosilicate glass film to be produced.

In accordance with a preferred embodiment of the present invention, a reaction gas mixture having a mol ratio of phosphine ($PH_3$) to phosphine and monosilane ($PH_3+SiH_4$) of 0.08 or less is used.

Particular embodiments of the method in accordance with this invention will now be described and contrasted with the prior art with reference to the accompanying drawings; in which:—

Figure 1 is a diagrammatic longitudinal section through a typical conventional reaction tube for low pressure chemical vapour deposition;

Figure 2 is a diagrammatic cross-section through a typical conventional reaction tube;

Figure 3 is a diagrammatic longitudinal section of one embodiment of a reaction tube for use in the present invention;

Figure 4 is a diagrammatic longitudinal section through another embodiment of a reaction tube for use in the present invention;

Figure 5 is a diagrammatic cross-section of the reaction tubes shown in Figures 3 and 4;

Figure 6 is a graph illustrating the correlation between the deposition rate of the phosphosilicate glass films and the position of the wafers along the reaction tube;

Figure 7 is a graph illustrating the correlation between the etch rate of the deposited phosphosilicate glass films and the position of the wafers along the reaction tube; and

Figure 8 is a graph illustrating the correlation between the stress in the phosphosilicate glass films deposited on wafers and the mol ratio of $PH_3$ to $PH_3 + SiH_4$ in the deposition reaction gas mixture.

A conventional low pressure chemical vapour deposition method will now be described. In this method, a phosphosilicate glass film is deposited on a substrate from a reaction gas mixture including $SiH_4$, $PH_3$ and $O_2$ under a low pressure (e.g. 133.32 Pa (1 Torr) or less) and at a temperature of 350 through 450°C.

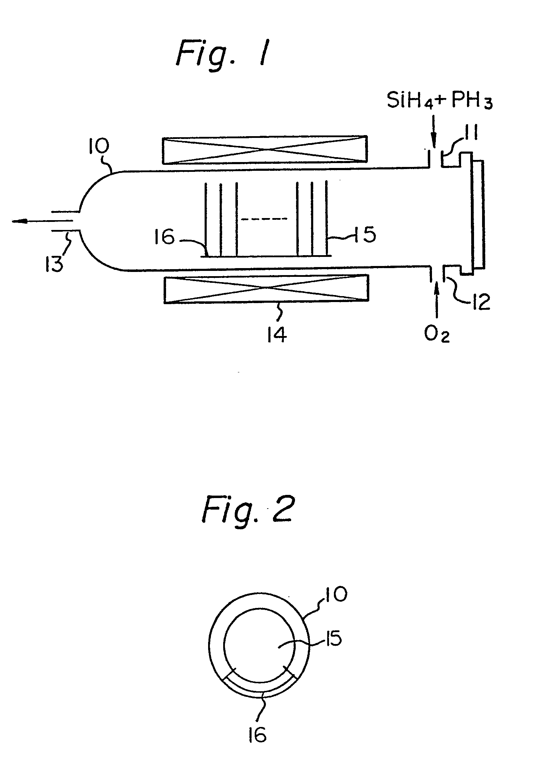

For instance, as shown in Figures 1 and 2, a reaction tube 10 made of, for example, quartz having an inner diameter of 120 mm diameter and a uniform heating zone length of approximately 100 mm is used for this purpose. In the reaction tube 10, gas inlets 11 and 12 are attached for feeding a gas mixture of $SiH_4$ and $PH_3$ and $O_2$ to one end thereof and an exhaust outlet 13 is attached to the other end thereof. Around the reaction tube 10, a heater 14 is mounted. In the practice of the chemical vapour deposition, plural substrates 15 for semiconductor devices made of, for example, silicon (i.e. wafers) are placed on a wafer holder 16 in such a state that the main surfaces of the wafers 15 are substantially parallel to one another and substantially perpendicularly intersect the central axis of the reaction tube 10. Then, a gas mixture of $SiH_4$ and $PH_3$ and an $O_2$ gas are fed from the gas inlets 11 and 12, while the inside of the reaction tube 10 is evacuated from the exhaust outlet 13 by means of a vacuum pump (not shown). Thus, phosphosilicate glass films are formed on the main surfaces of the wafers 15 under the conditions of, for example, a pressure of 66.66—133.32 Pa (0.5—1.0 Torr) and a temperature of approximately 425°C for 100 minutes.

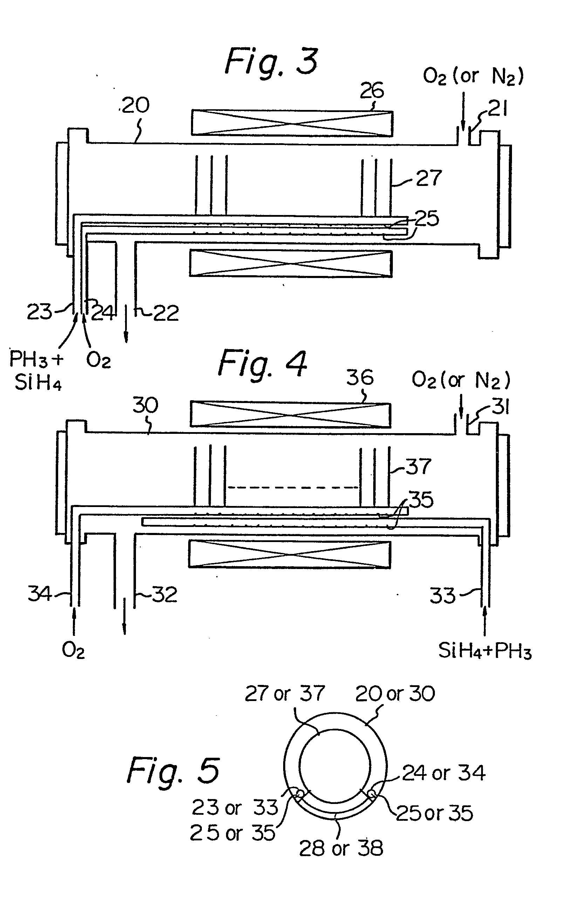

Referring to Figures 3, 4 and 5, typical examples of reaction tubes used in the practice of the present invention will now be explained. A reaction tube 20 or 30, made of, for example, quartz having an inner diameter of 120 mm diameter and a constant heating zone length of approximately 100 mm is provided with an $O_2$ gas inlet 21 or 31 at one end thereof and an exhaust outlet 22 or 32 at the other end thereof.

In the inside of the reaction tube 20 or 30, gas feed pipes 23 or 33 and 24 or 34 having plural small openings 25 or 33 pierced along the longitudinal direction thereof, as typically shown in Figures 3, 4 and 5, are mounted in the substantially full length of the constant heating portion of the reaction tube 20 or 30. In the practice of the present invention, a gas mixture of $PH_3$ and $SiH_4$ is fed through the small openings 25 or 35 of the pipe 23 or 33, whereas an $O_2$ gas is fed through the small openings 25 or 35 of the pipe 24 or 34. In the embodiment of Figure 3, both gas feed pipes 23 and 34 are inserted into the reaction tube 20 from one end portion thereof. It should be noted that these gas feed pipes 23 and 24 can also be inserted into the reaction tube 20 from the opposite end portion of the reaction tube 20. Contrary to this, in the embodiment of Figure 4, the gas feed pipes 33 and 34 are inserted into the reaction tube 30 from the different end portions thereof as shown in Fig. 4. It should be noted that the pipes 33 and 34 can also be exchangeable with each other. As shown in Fig. 5, the small openings 25 or 35 are desirably pierced in such a manner that the gas is outwardly and radially discharged from the openings. A heater 26 or 36 is mounted around the reaction tube 20 or 30, so that the constant heating zone of the reaction tube 20 or 30 can be uniformly heated to a desired temperature.

Although the embodiments of the reaction tubes in which two gas feed pipes 23 and 24 or 33 and 34 are mounted are illustrated in Figs. 3, 4 and 5, it should be noted that a gas mixture of $PH_3$ and $SiH_4$ and/or an $O_2$ gas can be fed through plural gas pipes and also that such plural pipes can be placed at any configuration in the cross section of the pipes.

In the practice of the deposition of phosphosilicate glass film on substrates, e.g. silicon wafers, plural wafers 27 or 37 are placed on a wafer holder 28 or 38 in such a state that the main surfaces of the wafers 27 or 37 are substantially parallel to one another and substantially perpendicularly intersect the central axis of the reaction tube 20 or 30. Then, a gas mixture of $SiH_4$ and $PH_3$ is fed from a gas inlet pipe 23 or 33 and an oxygen gas is fed from a gas inlet 21 or 31 and a gas feed pipe 24 or 34, while the inside of the reaction tube 20 or 30 is evacuated by means of a vacuum pump (not shown).

For instance, phosphosilicate glass films were deposited on the surfaces of silicon wafers by using a reaction tube as shown in Figs. 4 and 5 as follows.

In the uniform heating zone of the reaction tube 30 having a length of about 1 m and heated to a temperature of about 425°C, 70 pieces of sample silicon wafers 37 were placed at a distance of 15 mm. Further 20 pieces of dummy silicon wafers 37 were placed at each end of said sample silicon wafers 37. Thus, 110 pieces of silicon wafers 37 were present in the uniform heating zone of the reaction tube 30. The system within the reaction tube 30 was evacuated through the exhaust outlet 32 by means of a vacuum pump (not shown) and the temperature of the uniform heating zone of the reaction tube 30 was heated to a temperature of approximately 425°C by means of the heater 36. Thus, a reaction gas mixture of $SiH_4$ and $PH_3$ having a mol ratio of $PH_3$ to $PH_3$ and $SiH_4$ of 0.08 in a reaction gas mixture was fed through the pipe 33 at a gas feed rate of 44 cc/min and an $O_2$ gas was fed through the pipe 34 and the inlet nozzle 31 at a gas feed rate of 30 cc/min and 90 cc/min, respectively, while the pressure of the system is maintained at a vacuum pressure of 45 Pa (0.35 Torr). The gas feed volume ratio of $O_2$ to the mixture of $SiH_4$ was 3. The deposition of phosphosilicate glass films on the wafers 37 was carried out for 50 minutes under the above-mentioned conditions. As a result of an infrafed absorption spectrophotometric analysis, no substantial amount of $Si-H_2$ (or $Si_2O_3$) bond was included in the deposited phosphosilicate glass films on the sample silicon wafers.

On the other hand, the above-mentioned deposition of phosphosilicate glass films on silicon wafers was repeated, except that a conventional reaction tube 10 as shown in Figs. 1 and 2 was used, instead of the reaction tube 37 as shown in Figs. 4 and 5. As a result of the infrared absorption spectrophotometric analysis of the resultant phosphosilicate glass films deposited on the silicon wafers, it was observed hhat a substantial amount of $Si-H_2$ (or $Si_2O_3$) bond was included in the resultant phosphosilicate glass films.

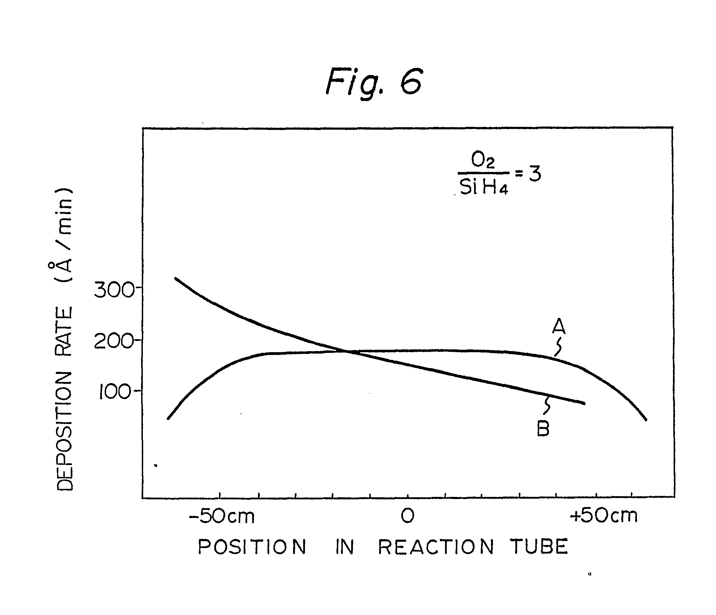

Furthermore, the correlations between the deposition rate (Å/min where 1 Å=$10^{-10}$m) of the phosphosilicate glass films on the silicon wafers and the position of the wafers placed in the heating zone of the reaction tube are shown in Fig. 6. The position of the wafers is represented by the distance (cm) from the center of the uniform heating zone of the reaction tube. In Fig. 6, a curve A represents the correlation obtained from the above-mentioned experiment according to the present invention in which the reaction tube 30 provided with two gas feed pipes 33 and 34, as shown in Figs. 4 and 5 was used, whereas a curve B represents the correlation obtained from the above-mentioned comparative experiment in which the reaction tube 10 provided with no gas feed pipe therein was used. As is clear from the results shown in Fig. 6, according to the present invention, the phosphosilicate glass films were substantially uniformly deposited on the surfaces of the 70 pieces of silicon wafer and the uniformity of the deposited films was remarkably improved as compared with the comparative experiment.

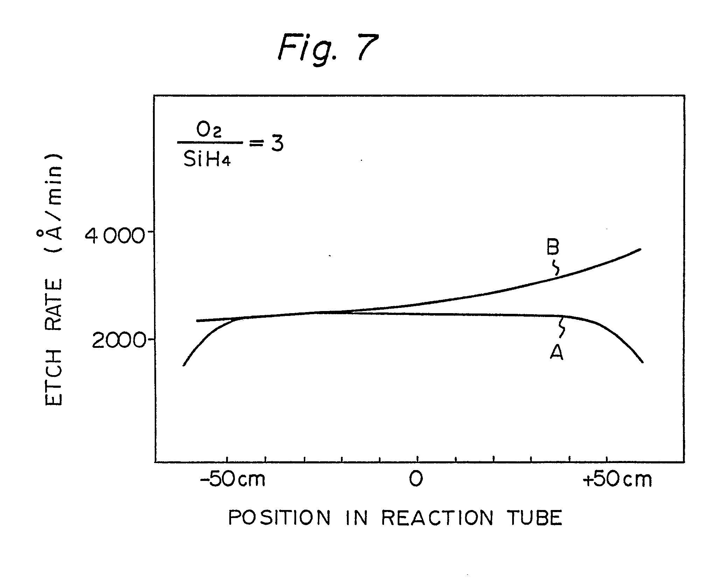

In addition, the correlations between the etch rate (Å/min) of the phosphosilicate glass films on the silicon wafers and the position of the wafers placed in the uniform heating zone of the reaction tube are shown in Fig. 7. The etching was carried out by using hydrogen fluoric acid under the conditions of a temperature of 20°C and the ratio of $HF:H_2O=1.25:98.75$. In Fig. 7, a curve A represents the correlation obtained from the above-mentioned experiment according to the present invention in which the reaction tube 30 provided with two gas feed pipes 33 and 34, as shown in Figs. 4 and 5 was used, whereas a curve B represents the correlation obtained from the above-mentioned comparative experiment in which the reaction tube 10 provided with no gas feed pipe therein was used.

As is clear from the results shown in Fig. 7, according to the present invention, the phosphosilicate glass films deposited on the surface of the 70 pieces of silicon wafers were uniformly etched at a substantially uniform etch rate and the uniformity in the etch rate of the deposited phosphosilicate glass films was remarkably improved as compared with the comparative experiment. Since the etch rate of the phosphosilicate glass films is proportional to the content of phosphorus in the deposited phosphosilicate glass films, the above results of the present invention means that the phosphorus was uniformly included in the phosphosilicate glass films deposited on the surface of the 70 pieces of silicon wafers.

In addition to the above-mentioned experiments, the deposition of the phosphosilicate glass films on silicon wafers was carried out by changing the gas feed rate. For instance, in the case of the gas feed mol ratio of $O_2$ to $SiH_4$ ($O_2/SiH_4$) of 2 (gas feed rate of $SiH_4$ and $PH_3$ was 44 cc/min), no $Si-H_2$ (or $Si_2O_3$) bond was included in the deposited phosphosilicate glass films. As the above-mentioned ratio of $O_2$ to $SiH_4$ is increased to 3 or 4, the mass productivity of the deposition of the phosphosilicate glass films on the surfaces of silicon wafers is gradually decreased. Therefore, the ratio of $O_2$ to $SiH_4$ and $PH_3$ is most desirably within the range of 2 through 3. Since the thickness of the phosphosilicate glass films on the wafers depends upon the feed amount of $SiH_4$ and the like, the use of too small amount of the feed rate of $SiH_4$ is not preferable.

In the case where the deposition of the phosphosilicate glass films on the wafers was carried out in a manner as described in the above-mentioned experiment, except that the reaction tube 20 as shown in Fig. 3 was used, instead of the reaction tube 30 as shown in Fig. 4, results similar to the above-mentioned results were obtained.

Although oxygen was fed through the inlet 21 or 31 in the above-mentioned experiments, nitrogen gas or the like can be fed through the inlet 21 or 31 to effect the smooth gas flow of the reaction gas mixture in the reaction tube, as long as a sufficient amount of oxygen can be fed through the pipe 24 or 34.

Thus, according to the present invention, the gas mixture of $SiH_4$ and $PH_3$ and the oxygen gas are separately fed to the reaction tube through the plural small openings 25 or 35 pierced in the pipes 23 and 24 or 33 and 34 and oxygen gas can be further fed from the gas inlet 21 or 31, no substantial amount of Si—$H_2$ (or $Si_2O_3$) bond is included in the deposited phosphosilicate glass films and the phosphosilicate glass films having a uniform thickness and uniform film quality can be deposited on substrates.

As mentioned hereinabove, according to the preferred embodiment of the present invention, a reaction gas mixture having a mol ratio of $PH_3$ to $PH_3$ and $SiH_4$ ($PH_3/PH_3+SiH_4$) of 0.08 or less, preferably 0.03 through 0.08, is used to obtain the deposited phosphosilicate glass films having a low phosphorus content at a high mass productivity and in which no substantial cracking occurs during, for example, the annealing step of the semiconductor device.

The experimental results obtained from the use of the reaction tube 30 as shown in Figs. 4 and 5 will now be explained.

In the uniform heating zone of the reaction tube 30 having a length of about 2 m and heated to a temperature of about 425°C, sample silicon wafers 37 were placed with a distance of 15 mm. The system within the reaction tube 30 was evacuated from the exhaust outlet 32 by means of a vacuump pump (not shown) and maintained under a vacuum pressure of 13.33 through 26.66 Pa (0.1 through 0.2 Torr) during the deposition experiment. Thus, phosphosilicate glass films were deposited on the surfaces of the silicon wafers in the form of discs each having a diameter of 10.0 cms (4 inches) by using various gas feed rates of $O_2$ gas and a gas mixture of $SiH_4$ and $PH_3$. The oxygen gas was fed through the many small openings of the pipe 34, and the gas inlet 31 and the gas mixture of $SiH_4$ and $PH_3$ was fed through the many small openings 35 of the pipe 33.

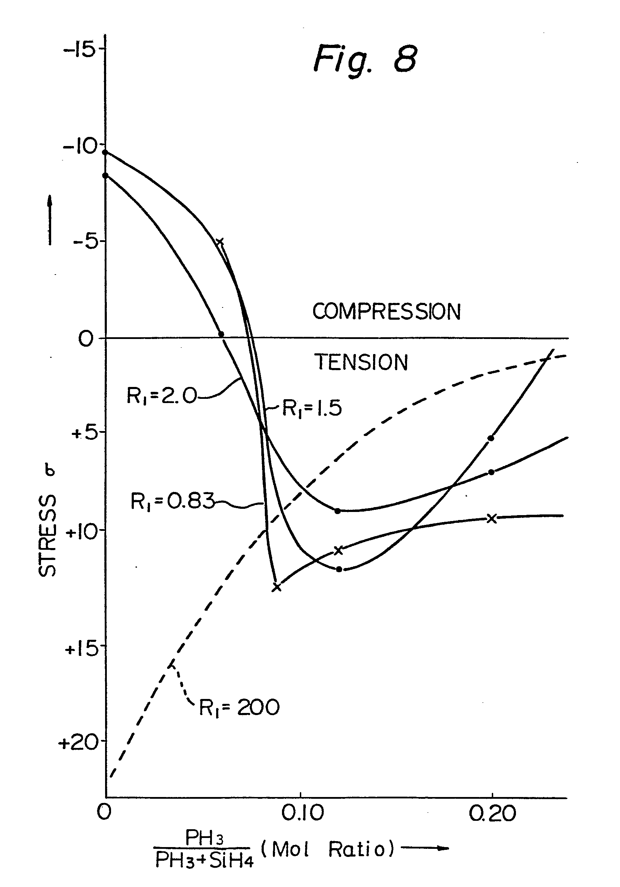

The correlation between the stress of the phosphosilicate glass films deposited on the wafers and the mol ratio of $PH_3$ (mol) to $SiH_4$ (mol) and $PH_3$ (mol) in the reaction gas mixture, which was obtained from a series of the experiments is shown in Fig. 8. In Fig. 8, $R_1$ represents a mol ratio of $O_2$ (mol) to $SiH_4$ (mol) contained in the total reaction gas mixture. In the case of $R_1=200$, the deposition was carried out under an atmospheric pressure. The stress σ of each phosphosilicate glass film having a thickness of 1 micron at a room temperature was determined according to a so-called Newton ring method.

As shown in Fig. 8, in the case of the mol ratio of $PH_3$ to $PH_3$ and $SiH_4$ of 0.08 or less, the deposited phosphosilicate glass films are under compressive stress (i.e. the phosphosilicate glass films become convex). Contrary to this, in the case of the mol ratio of $PH_3$ to $PH_3$ and $SiH_4$ of more than 0.08, the deposited phosphosilicate glass films are under tensile stress (i.e. the phosphosilicate glass films become concave). This means that, in the case where the phosphosilicate glass films are deposited on silicon wafers at a mol ratio of $PH_3/PH_3+SiH_4$ of 0.08 or less, it is difficult for cracking to be generated in the deposited phosphosilicate glass films since the resultant deposited films are under compressive stress. This is because, in the case where the deposited phosphosilicate glass films are under compressive stress, the stress does not become larger at a room temperature when the films are annealed at a room temperature.

Referring to the dotted curve in Fig. 8, in the case where the phosphosilicate glass films are deposited at $R_1$ of 200 according to a so-called atmospheric pressure chemical vapor deposition method, the cracking readily occurs especially in the field of low phosphorus content (i.e. the tensile stress is increased with the decrease in $PH_3$ content in the reaction gas mixture).

In order to actually observe the generation of the cracking in the deposited phosphosilicate glass films, the following two series of experiments were carried out.

In the first experiments, aluminum layers each having a thickness of 1 micron were first deposited on the entire main surfaces of silicon wafers in the form of discs each having a diameter of 100 mm (4 inches) and, then, phosphosilicate glass films each having a thickness of 1 micron were deposited on the surfaces of the aluminum layers. The deposition of the phosphosilicate glass films was carried out under the following conditions.

Pressure:
    13.33—26.66 Pa (0.1—0.2 Torr.

Temperature:
    425°C.

Mol Ratio of $O_2/SiH_4$ ($R_1$):
    listed in Table 1 below.

Mol Ratio of $PH_3/PH_3+SiH_4$ ($R_2$):
    listed in Table 1 below.

The generation of cracking of the resultant phosphosilicate glass films was observed at a temperature of 450°C. The results are shown in the following Table 1.

TABLE 1

| $R_1$ | $R_2$ | 1c | 2c | 3c | 4c | 5c |
|---|---|---|---|---|---|---|
| 0.83 | 0 | − | − | − | − | − |
| | 0.06 | − | − | − | − | − |
| | 0.09 | + | + | + | +++ | +++ |
| | 0.12 | − | + | + | + | + |
| | 0.20 | − | − | − | − | − |
| 1.2 | 0 | − | − | − | − | − |
| | 0.09 | − | + | + | ++ | ++ |
| 1.5 | 0 | − | − | − | − | − |
| | 0.06 | − | − | − | − | − |
| | 0.08 | − | − | − | + | + |
| | 0.09 | + | + | + | ++ | ++ |
| | 0.10 | − | − | + | + | + |
| | 0.12 | − | − | − | − | − |
| | 0.20 | − | − | − | − | − |
| 2.0 | 0 | − | − | − | − | − |
| | 0.06 | − | − | − | − | − |
| | 0.09 | + | + | + | + | + |
| | 0.12 | − | − | − | − | − |
| | 0.20 | − | − | − | − | − |

−: No cracking.
+: Cracking in the edge portion (of wafer) having a width of 1 mm.
++: Cracking in the edge portion having a width of 2 mm.
+++: Cracking in the edge portion having a width of 5 mm.

In the second experiment, a specified aluminum pattern having a thickness of 1 micron was formed on the main surfaces of silicon wafers and, then, phosphosilicate glass films each having a thickness of 1 micron were deposited on the aluminum pattern. The deposition of the phosphosilicate glass films was carried out under the following conditions.

Pressure:
13.33—26.66 Pa (0.1—0.2 Torr).
Temperature:
425°C.

$R_1$:
listed in Table 2 below.
$R_2$:
listed in table 2 below.

The generation of cracking of the resultant phosphosilicate glass films was observed at a temperature of 450°C. The results are shown in the following Table 2.

TABLE 2

| $R_1$ | $R_2$ | 1c | 2c | 3c | 4c | 5c |
|---|---|---|---|---|---|---|
| 0.83 | 0 | − | − | − | − | − |
| | 0.06 | − | − | − | − | − |
| | 0.09 | − | − | + | + | + |
| | 0.12 | − | − | − | − | − |
| | 0.20 | − | − | − | − | − |
| 1.2 | 0 | − | − | − | − | − |
| | 0.09 | − | − | − | + | + |
| 1.5 | 0 | − | − | − | − | − |
| | 0.06 | − | − | − | − | − |
| | 0.08 | − | − | − | − | − |
| | 0.09 | − | − | + | ++ | ++ |
| | 0.10 | − | − | + | + | + |
| | 0.12 | − | − | − | − | − |
| | 0.20 | − | − | − | − | − |
| 2.0 | 0 | − | − | − | − | − |
| | 0.06 | − | − | − | − | − |
| | 0.09 | − | − | + | + | + |
| | 0.12 | − | − | − | − | − |
| | 0.20 | − | − | − | − | − |

−: No cracking.
+: Cracking in the edge portion (of wafer) having a width of 1 mm.
++: Cracking in the edge portion having a width of 2 mm.

In the results shown in Tables 1 and 2, 1c, 2c, 3c, 4c and 5c represent the number of the heat cycles at 450°C in nitrogen atmosphere (1 cycle was 30 minutes).

As is clear from the results shown in Tables 1 and 2, in the phosphosilicate glass films deposited at a mol ratio of $PH_3$ to $PH_3$ and $SiH_4$ (i.e. $R_2$) of 0.08 or less, no cracking was generated in the (practical) area of the semiconductor device irrespective of the mol ratio of $O_2$ to $SiH_4$ (i.e. $R_1$). It should be noted that similar results would be obtained in the phosphosilicate glass films as interlaminar insulating films and passivation films.

As is clear from the results shown in Tables 1 and 2, no cracking was also generated in the phosphosilicate glass films deposited at a mol ratio $R_2$ of 0.12 to 0.20. However, in the case where the phosphorus content in the phosphosilicate glass film becomes large, the water vapor resistance is undesirably decreased because of the absorption of water due to the presence of phosphoric acid formed in the film. Especially when the phosphosilicate glass films are used as a cover film for semiconductor device, the decrease in the water vapor resistance of the film should be avoided. For this reason, the use of $R_2$ of 0.08 or less is desirable. On the other hand, when the phosphosilicate glass film is used as an interlaminar insulation film of wire pattern layers, the films deposited at a mol ratio $R_2$ of larger than 0.08 are acceptable and rather preferable. This is because, when the heat treatment is carried out to make the edge portion of the through-hole gentle, more gentle edge portions can be readily formed due to the fact that the phosphosilicate glass film is easy to melt as the phosphorus content of the film is high.

As mentioned hereinabove, according to the present invention, since the deposition of the phosphosilicate glass films is carried out according to a low pressure method, the phosphosilicate glass films can be simultaneously deposited on the surfaces of a lot of substrates to be treated placed in the reaction tube at an extremely high mass productivity.

Furthermore, since a deposition gas mixture having an extremely low mol concentration of $PH_3$ is used in the deposition of phosphosilicate glass films in a preferred example of the present invention, the phosphorus content in the resultant phosphosilicate glass films is extremely low and, as a result, the water-vapour resistance of the deposited films in this example is excellent. In addition, since phosphosilicate glass films having compressive stress are formed according to a preferred example of the present invention, the generation of heat cracking in such phosphosilicate glass films is largely obviated.

Consequently, since phosphosilicate glass films having the above-mentioned advantages can be deposited, as interlaminar insulating films or passivation films, on the substrates for semiconductor devices suitable for use in semiconductor integrated circuits, the reliability of the semiconductor devices is remarkably improved.

## Claims

1. A method of forming a phosphosilicate glass film during the manufacture of a semiconductor device including the steps of: placing a number of semiconductor substrates (27) to be treated in an elongate reaction tube (20) with the principal surfaces of the substrates (27) substantially parallel to one another and substantially perpendicular to the longitudinal axis of the reaction tube (20 or 30), introducing a silicon compound gas and an oxidising gas into the reaction tube (20 or 30) through at least two gas feed pipes (33 and 34) both having gas outlets (25, 35) distributed along them and arranged along the inside of the reaction tube (20), the silicon compound gas being introduced through one of the gas feed pipes (33) and the oxidising gas being introduced through another of the gas feed pipes (34), while maintaining the inside of the reaction tube (20 or 30) at a reduced low pressure so that phosphosilicate glass films are deposited on the principal surfaces of the substrates (27), characterised in that a gas is fed through an inlet (21 or 31) into the reaction tube (20 or 30) at the same time as the silicon compound gas and the oxidising gas to ensure a smooth flow of the silicon compound gas and the oxidising gas mixture through the reaction tube (20 or 30).

2. A method according to claim 1, wherein the silicon compound gas includes monosilane ($SiH_4$) and phosphine ($PH_3$) and the oxidising gas includes oxygen ($O_2$).

3. A method according to claim 2, wherein the mol ratio of phosphine to phosphine and monosilane ($PH_3/PH_3+SiH_4$) in the silicon compound gas is 0.08 or less.

4. A method according to anyone of the preceding claims, wherein the gas outlets (25, 35) distributed along the gas feed pipes (33, 34) are formed by a number of small holes arranged to direct streams of gas around the walls of the reaction tube (20).

5. A method according to any one of the preceding claims, in which the gas fed through the inlet (21 or 31) is oxygen or nitrogen.

## Revendications

1. Procédé de formation d'une pellicule de verre de phosphosilicate pendant la fabrication d'un dispositif semiconducteur comportant les opérations suivanates: placer un certain nombre de semiconducteurs (27) à traiter dans un tube de réaction allongé (20) de façon que les surfaces principales des substrats (27) soient sensiblement parallèles entre elles et soient sensiblement perpendiculaires à l'axe longitudinal du tube de réaction (20 ou 30), introduire un composé gazeux de silicium et un gaz oxydant dant le tube de réaction (20 ou 30) par au moins deux tuyaux (33 et 34) d'alimentation en gaz possèdant tous deux des sorties de gaz (25, 35) réparties sur leur longueur et placées le long de l'intérieur du tube de réaction (20), le composé gazeux de silicium étant introduit par l'un des tuyaux d'alimentation en gaz (33) et le gaz oxydant étant introduit par l'autre des tuyaux d'alimentation en gaz (34), tandis qu'il est maintenu à l'intérieur du tube de réaction (20 ou 30) une basse pression réduite, de sorte que les pellicules de verre de phosphosilicate se déposent sur les surfaces principales des substrats (27), caractérisé en ce qu'un gaz est délivré par une entrée (21 ou 31) dan le tube de réaction (20 ou 30) en même temps que le composé gazeux de silicium et le gaz oxydant afin d'assurer un écoulement régulier du composé gazeux de silicium et du gaz oxydant dans le tube de réaction (20 ou 30).

2. Procédé selon la revendication 1, où le composé gazeux de silicium comporte le monosilane ($SiH_4$) et la phosphine ($PH_3$), et le gaz oxydant comporte l'oxygène ($O_2$).

3. Procédé selon la revendication 2, où le rapport molaire de la phosphine à l'ensemble phosphine et monosilane ($PH_3/(PH_3+SiH_4)$) dans le composé gazeux de silicium vaut 0,08 ou moins.

4. Procédé selon l'une quelconque des revendications précédentes, où les sorties de gaz (25, 35) réparties suivant la longueur des tuyaux d'alimentation en gaz (33, 34) sont formées par un certain nombre de petits trous disposés de façon à diriger des courants de gaz autour des parois du tube de réaction (20).

5. Procédé selon l'une quelconque des revendications précédentes, dans lequel le gaz délivré par l'entrée (21 ou 31) est de l'oxygène ou de l'azote.

**Patentansprüche**

1. Verfahren zur Bilding eines Phosphorsilikatglasfilms während der Herstellung einer Halbleitervorrichtung, mit den folgenden Schritten:

Anordnen einer Anzahl von zu behandelnden Halbleitersubstraten (27) in einem länglichen Reaktionsrohr (20), mit den Hauptoberflächen der Substrate (27) im wesentlichen parallel zueinander und im wesentlichen senkrecht zu der Längsachse des Reaktionsrohres (20 oder 30),

Einführen eines Siliziumverbindungsgases und eines oxidierenden Gases in das Reaktionsrohr (20 oder 30) durch wenigstens zwei Gaszuführungsleitungen (33 und 34), die beide Gasauslaßöffnungen (25 und 35) haben, die längs ihnen und längs der Innenseite des Reaktionsrohres (20) verteilt sind, wobei das Siliziumverbindungsgas durch eine der Gaszuführungsleitungen (33) und das oxidierende Gas durch die andere Gaszuführungsleitung (34) zugeführt werden, während die Innenseite des Reaktionsrohres (20 oder 30) auf einem reduzierten Niederdruck gehalten wird, so daß Phosphorsilikatglasfilme auf den Hauptoberflächen der Substrate (27) niedergeschlagen werden,

dadurch gekennzeichnet, daß gleichzeitig mit dem Siliziumverbindungsgas und dem oxidierenden Gas ein Gas durch einen Einlaß (21 oder 31) in das Reaktionsrohr (20 oder 30) eingeführt wird, um eine gleichmäßige Strömung der Mischung aus Siliziumverbindungsgas und aus oxidierendem Gas durch das Reaktionsrohr (20 oder 30) zu gewährleisten.

2. Verfahren nach Anspruch 1, bei welchem das Siliziumverbindungsgas Monosilan ($SiH_4$) und Phosphin ($PH_3$) und das oxidierende Gas Sauerstoff ($O_2$) umfaßt.

3. Verfahren nach Anspruch 2, bei welchem das Molenverhältnis von Phosphin zu Phosphin und Monosilan ($PH_3/PH_3+SiH_4$) in dem Siliziumverbindungsgas 0,08 oder kleiner ist.

4. Verfahren nach einem der vorhergehenden Ansprüche, bei welchem die längs den Gaszuführungsleitungen (33, 34) verteilten Gasauslaßöffnungen (25, 35) durch eine Anzahl kleiner Löcher gebildet sind, welche so angeordnet sind, daß sie Gasströme um die Wände des Reaktionsrohres (20) richten.

5. Verfahren nach einem der vorhergehenden Ansprüche, bei welchem das durch Einlässe (21 oder 31) eingeführte Gas Sauerstoff oder Stickstoff ist.

Fig. 1

Fig. 2

Fig. 3

Fig. 4

Fig. 5

## Fig. 6

$\frac{O_2}{SiH_4} = 3$

DEPOSITION RATE (Å / min)

300

200

100

A

B

−50cm

O

+50cm

POSITION IN REACTION TUBE

## Fig. 7

*Fig. 8*